# EUROPEAN PATENT APPLICATION

(11) **EP 4 804 746 A1**
(43) Date of publication of application: **09.09.2026**
(21) Application number: 25222201.3
(22) Date of filing: 10.12.2025
(51) Int. Cl.: H05K 7/20, H05K 5/02, H10W 40/22

(54) **HEAT SINK UNIT, ELECTRONIC ARRANGEMENT, AND ROBOTIC LAWNMOWER**

(30) Priority: 06.03.2025 SE 2550210
(71) Applicant: Husqvarna AB, 561 82 Huskvarna (SE)
(72) Inventor: Allard, Martin, 561 82 Huskvarna (SE)

(57) **Abstract**

A heat sink unit (1) is disclosed configured to conduct heat away from an electronic assembly (3). The heat sink unit (1) comprises a top side (11) comprising a plurality of heat sink members (11') and a bottom side (12) comprising a heat transferring section (2, 2') configured to be in heat exchanging contact with a portion (13, 13') of the electronic assembly (3). The bottom side (12) comprises a number of profiled surfaces (s1, s2, s3, s4) each comprising a series of adjacent ridges (4) and grooves (6). The present disclosure further relates to an electronic arrangement (10) and a robotic lawnmower (30).

## Description

### TECHNICAL FIELD

The present disclosure relates to a heat sink unit configured to conduct heat away from an electronic assembly. The present disclosure further relates to an electronic arrangement comprising an electronic assembly and a heat sink unit, as well as a robotic lawnmower comprising a heat sink unit.

### BACKGROUND

Many electrical components used in electronic assemblies generate heat during operation. A heat sink unit can be used to transfer heat from these components to the surroundings. Components that typically generate significant heat include power transistors, voltage regulators, microprocessors, and other discrete or integrated circuit components. These components may be arranged on a circuit board, such as a printed circuit board, which forms part of an electronic assembly.

A robotic lawnmower is a type of apparatus capable of cutting grass in areas in an autonomous manner, i.e., in a manner not requiring direct human intervention. Some robotic lawnmowers require a user to set up a border wire around a lawn that defines the area to be mowed. Such robotic lawnmowers use a sensor to locate the wire and thereby determine the boundary of the area to be trimmed. In addition to the wire, robotic lawnmowers may also comprise other types of positioning units and sensors, for example, sensors for detecting an event, such as a collision with an object within the area.

The robotic lawnmower may move in a systematic and/or random pattern to ensure that the area is completely cut. A robotic lawnmower usually comprises one or more batteries and one or more electrically driven cutting units powered by the one or more batteries. In some cases, the robotic lawnmower uses the wire to locate a recharging dock used to recharge the one or more batteries. Generally, robotic lawnmowers operate unattended within the area in which they operate. Examples of such areas include lawns, gardens, parks, sports fields, golf courses, and similar environments.

Robotic lawnmowers usually comprise an electronic assembly that may need to be cooled during operation. This can be solved by arranging a heat sink unit in thermal communication with the electronic assembly. The electronic assembly in a robotic lawnmower may be configured to control different functions of the robotic lawnmower, such as processing data from sensors, controlling the movement of the lawnmower, managing the battery charging process, or operating the cutting unit. Some robotic lawnmowers may also comprise imaging units, which may require control circuits that generate additional heat during operation.

A heat sink unit can be arranged to conduct heat away from an electronic assembly to maintain its temperature within an acceptable range. A heat sink unit may comprise a top side comprising a plurality of heat sink members and a bottom side comprising a heat-transferring section configured to be in heat-exchanging contact with a portion of the electronic assembly. This can improve the thermal performance of the electronic assembly by dissipating heat to the surroundings.

Electronic assemblies are usually sensitive to moisture. Exposure to moisture can lead to corrosion, short circuits, and degradation of electrical components, which may result in malfunctions or failures. When cycling temperatures from high to low, moisture in the air cools down and condenses on cooler surfaces. This can become a problem when a heat sink and the electronic assembly are mounted on the bottom of the heat sink, as condensed water may build up and drip onto the electronic assembly, potentially causing failures.

One way of addressing this problem is to use a fan to generate an airflow over the electronic assembly and the heat sink unit. By promoting air movement, the fan can reduce the likelihood of condensation forming on the surfaces. However, in an apparatus such as a robotic lawnmower, this type of arrangement may have drawbacks. A fan requires energy to operate, which can reduce the available battery power for other functions of the robotic lawnmower. Additionally, condensation on the heat sink unit typically occurs when the apparatus is not in use, meaning that a fan may not effectively prevent the problem in such situations.

Therefore, there is a need for a heat sink unit and an electronic arrangement that can address the problem of condensation while efficiently conducting heat away from an electronic assembly.

### SUMMARY

It is an object of the present invention to overcome, or at least alleviate, at least some of the above-mentioned problems and drawbacks. The object is achieved by the subject-matter of the appended independent claim(s).

According to a first aspect of the present disclosure, the object is achieved by a heat sink unit configured to conduct heat away from an electronic assembly, the heat sink unit comprising a top side comprising a plurality of heat sink members and a bottom side comprising a heat transferring section configured to be in heat exchanging contact with a portion of the electronic assembly. The bottom side further comprises a number of profiled surfaces each comprising a series of adjacent ridges and grooves.

Since the bottom side of the heat sink unit comprises the number of profiled surfaces each comprising a series of adjacent ridges and grooves, a heat sink unit is provided in which moisture formed on the bottom side can be efficiently transferred therefrom in a controlled manner to avoid dripping onto an electronic assembly used with the heat sink unit.

In other words, due to these features, a heat sink unit is provided that can ensure more reliable operation of an electronic assembly used with the heat sink unit.

Furthermore, a heat sink unit is provided that can transfer moisture away from a sensitive electronic assembly in a passive manner, not requiring the input of electrical energy. **In** this manner, the heat sink unit can prevent moisture from reaching an electronic assembly even when it is arranged in an apparatus that is turned off.

Accordingly, a heat sink unit is provided overcoming, or at least alleviating, at least some of the above-mentioned problems and drawbacks. As a result, the above-mentioned object is achieved.

The wording "number of profiled surfaces", as used herein, means one or more profiled surfaces. That is, according to embodiments herein, the number of profiled surfaces may comprise one profiled surface only, or two or more profiled surfaces.

Optionally, the distance between two adjacent ridges of the number of profiled surfaces is within the range of 0.5 - 5.5 millimetres, or is within the range of 1.5 - 2.3 millimetres. Thereby, the number of profiled surfaces can effectively collect moisture, such as condensed water, on the bottom side of the heat sink unit, and efficiently direct it away from an electronic assembly used with the heat sink unit.

Optionally, the distance between a peak of the ridges and a valley of the grooves is within the range of 0.15 - 1.5 millimetres, or is within the range of 0.34 - 0.54 millimetres. Thereby, the number of profiled surfaces can effectively collect moisture, such as condensed water, on the bottom side of the heat sink unit, and efficiently direct it away from an electronic assembly used with the heat sink unit.

Optionally, the heat sink unit is configured to be mounted to an apparatus such that, when the apparatus is in an upright use position on a flat horizontal surface, a vertical direction of the heat sink unit coincides with the gravity vector, and wherein each of the number of profiled surfaces is inclined relative to a horizontal plane of the heat sink unit, the horizontal plane being perpendicular to the vertical direction of the heat sink unit. Thereby, it can be ensured that each of the number of profiled surfaces can efficiently direct collected moisture away from an electronic assembly used with the heat sink unit through gravitational drainage.

Optionally, the number of profiled surfaces comprises a first profiled surface and a first moisture collecting ridge arranged adjacent to the first profiled surface. Thereby, it can be ensured that moisture collected on the first profiled surface can be efficiently transferred therefrom in a controlled manner via the first moisture collecting ridge, thereby avoiding dripping onto an electronic assembly used with the heat sink unit.

Optionally, the first profiled surface is inclined towards the first moisture collecting ridge. Thereby, it can be ensured that any moisture collected on the first profiled surface can be efficiently transferred to the first moisture collecting ridge due to gravity.

Optionally, the angle between the first profiled surface and the horizontal plane is within the range 7 - 45 degrees, or is within the range of 10 - 20 degrees. Thereby, it can be ensured that any moisture collected on the first profiled surface can be efficiently transferred along the first profiled surface due to gravity.

Optionally, the angle between the extension direction of the first moisture collecting ridge and the horizontal plane is within the range of 7 - 45 degrees, or is within the range of 10 - 20 degrees. Thereby, it can be ensured that any moisture on the first moisture collecting ridge can be efficiently transferred along the first moisture collecting ridge due to gravity, directing the moisture away from an electronic assembly used with the heat sink unit.

Optionally, the number of profiled surfaces comprises a second profiled surface, and wherein the first moisture collecting ridge is arranged between the first and second profiled surfaces. Thereby, by comprising more than one profiled surface, a relatively large surface area can be covered while avoiding the need for a single large profiled surface. In this manner, space efficiency can be ensured while also enabling efficient transfer of condensed moisture away from the bottom side of the heat sink unit. In addition, space efficiency is further improved because one moisture collecting ridge, i.e., the first moisture collecting ridge, can be used to direct collected moisture from both the first and second profiled surfaces in a controlled manner, avoiding dripping onto an electronic assembly used with the heat sink unit.

Optionally, the second profiled surface is inclined towards the first moisture collecting ridge. Thereby, it can be ensured that any moisture collected on the second profiled surface can be efficiently transferred to the first moisture collecting ridge due to gravity.

Optionally, the angle between the second profiled surface and the horizontal plane is within the range 7 - 45 degrees, or is within the range of 10 - 20 degrees. Thereby, it can be ensured that any moisture collected on the second profiled surface can be efficiently transferred along the first profiled surface due to gravity, directing the collected moisture away from an electronic assembly used with the heat sink unit.

Optionally, the series of ridges and grooves of the first and second profiled surfaces meet at an obtuse angle. Thereby, it can be ensured that moisture collected on the first and second profiled surfaces is efficiently transferred to the first moisture collecting ridge.

Optionally, the number of profiled surfaces comprises a third profiled surface and a second moisture collecting ridge arranged adjacent to the third profiled surface. Thereby, by comprising a third profiled surface, a relatively large surface area can be covered while avoiding the need for a single large profiled surface. **In** this manner, space efficiency can be ensured while also enabling efficient transfer of condensed moisture away from the bottom side of the heat sink unit.

Optionally, the third profiled surface is inclined towards the second moisture collecting ridge. Thereby, it can be ensured that any moisture collected on the third profiled surface can be efficiently transferred to the second moisture collecting ridge due to gravity.

Optionally, the angle between the extension direction of the second moisture collecting ridge and the horizontal plane is within the range of 7 - 45 degrees, or is within the range of 10 - 20 degrees. Thereby, it can be ensured that any moisture on the second moisture collecting ridge can be efficiently transferred along the second moisture collecting ridge due to gravity, directing the moisture away from an electronic assembly used with the heat sink unit.

Optionally, the number of profiled surfaces comprises a fourth profiled surface, and wherein the second moisture collecting ridge is arranged between the third and fourth profiled surfaces. Thereby, a relatively large surface area can be covered, ensuring space efficiency while also enabling efficient transfer of condensed moisture away from the bottom side of the heat sink unit. **In** addition, space efficiency is further improved because one moisture collecting ridge, i.e., the second moisture collecting ridge, can be used to direct collected moisture from both the third and fourth profiled surfaces in a controlled manner, avoiding dripping onto an electronic assembly used with the heat sink unit.

Optionally, the fourth profiled surface is inclined towards the second moisture collecting ridge. Thereby, it can be ensured that any moisture collected on the fourth profiled surface can be efficiently transferred to the second moisture collecting ridge due to gravity.

Optionally, the angle between each of the third and fourth profiled surfaces and the horizontal plane is within the range 7 - 45 degrees, or is within the range of 10 - 20 degrees. Thereby, it can be ensured that any moisture collected on the third and fourth profiled surfaces can be efficiently transferred along the profiled surface due to gravity, directing the collected moisture away from an electronic assembly used with the heat sink unit.

Optionally, the series of ridges and grooves of the third and fourth profiled surfaces meet at an obtuse angle. Thereby, it can be ensured that moisture collected on the third and fourth profiled surfaces is efficiently transferred to the second moisture collecting ridge.

Optionally, the heat sink unit is formed from a die-cast aluminium alloy. This material choice can provide advantages such as high thermal conductivity, durability, lightweight properties, and cost-efficient manufacturing.

According to a second aspect of the present disclosure, the object is achieved by an electronic arrangement comprising an electronic assembly and a heat sink unit according to the first aspect of the present disclosure, wherein the electronic assembly is attached to the heat sink unit such that a portion of the electronic assembly is in heat exchanging contact with the heat transferring section of the heat sink unit.

Since the electronic arrangement comprises a heat sink unit according to the first aspect of the present disclosure, an electronic arrangement is provided in which moisture formed on the bottom side of the heat sink unit can be efficiently transferred away in a controlled manner to avoid dripping onto the electronic assembly. In other words, due to these features, an electronic arrangement is provided that can ensure more reliable operation of the electronic assembly.

Furthermore, an electronic arrangement is provided that can transfer moisture away from the electronic assembly in a passive manner, not requiring the input of electrical energy. In this manner, the heat sink unit of the electronic arrangement can prevent moisture from reaching the electronic assembly even when the electronic arrangement is placed in an apparatus that is turned off.

Accordingly, an electronic arrangement is provided overcoming, or at least alleviating, at least some of the above-mentioned problems and drawbacks. As a result, the above-mentioned object is achieved.

Optionally, the electronic assembly comprises a circuit board and a number of electrical components arranged on the circuit board. Thereby, an electronic arrangement is provided in which moisture formed on the bottom side of the heat sink unit can be efficiently transferred therefrom in a controlled manner to avoid dripping onto the circuit board and the number of electrical components arranged on the circuit board. In other words, an electronic arrangement is provided that can ensure reliable operation of the number of electrical components arranged on the circuit board.

Optionally, the electronic assembly comprises at least one electronic control unit. Thereby, an electronic arrangement is provided in which moisture formed on the bottom side of the heat sink unit can be efficiently transferred therefrom in a controlled manner to avoid dripping onto the electronic control unit. In other words, an electronic arrangement is provided capable of ensuring reliable operation of the electronic control unit.

According to a third aspect of the present disclosure, the object is achieved by a robotic lawnmower comprising a heat sink unit according to the first aspect of the present disclosure or an electronic arrangement according to the second aspect of the present disclosure.

Thereby, a robotic lawnmower is provided in which dripping onto an electronic assembly of the lawnmower can be efficiently avoided. In this manner, operational reliability of the robotic lawnmower can be ensured.

Furthermore, since the heat sink unit can transfer moisture away from the electronic assembly in a passive manner, not requiring the input of electrical energy, the heat sink unit can prevent moisture from reaching the electronic assembly even when the robotic lawnmower is turned off and not in use.

Accordingly, a robotic lawnmower is provided overcoming, or at least alleviating, at least some of the above-mentioned problems and drawbacks. As a result, the above-mentioned object is achieved.

It will be appreciated that the various embodiments described for the method are all combinable with the control arrangement as described herein. That is, the control arrangement according to the fourth aspect of the invention may be configured to perform any one of the method steps of the method according to the first aspect of the invention.

Further features of, and advantages with, the present invention will become apparent when studying the appended claims and the following detailed description.

### BRIEF DESCRIPTION OF THE DRAWINGS

Various aspects of the present disclosure, including its particular features and advantages, will be readily understood from the example embodiments discussed in the following detailed description and the accompanying drawings, in which:
Fig. 1 schematically illustrates a perspective view of a robotic lawnmower,
Fig. 2 schematically illustrates a perspective view of an electronic arrangement of the robotic lawnmower illustrated in Fig. 1,
Fig. 3 illustrates a perspective view of a heat sink unit of the electronic arrangement illustrated in Fig. 2,
Fig. 4 illustrates a bottom view of the heat sink unit illustrated in Fig. 3,
Fig. 5 illustrates a perspective view of an electronic assembly of the electronic arrangement illustrated in Fig. 2,
Fig. 6 illustrates a side view of the heat sink unit of the electronic arrangement illustrated in Fig. 2,
Fig. 7 illustrates a perspective view of the heat sink unit of the electronic arrangement illustrated in Fig. 2, wherein the heat sink unit is seen towards a bottom side thereof,
Fig. 8 illustrates a cross section of the heat sink unit illustrated in Fig. 6, and
Fig. 9 illustrates a cross-section of a portion of the heat sink unit of the electronic arrangement illustrated in Fig. 2, wherein the portion comprises a first profiled surface of the bottom side of the heat sink unit.

### DETAILED DESCRIPTION

Aspects of the present disclosure will now be described more fully. Like reference signs refer to like elements throughout. Well-known functions or constructions will not necessarily be described in detail for brevity and/or clarity.

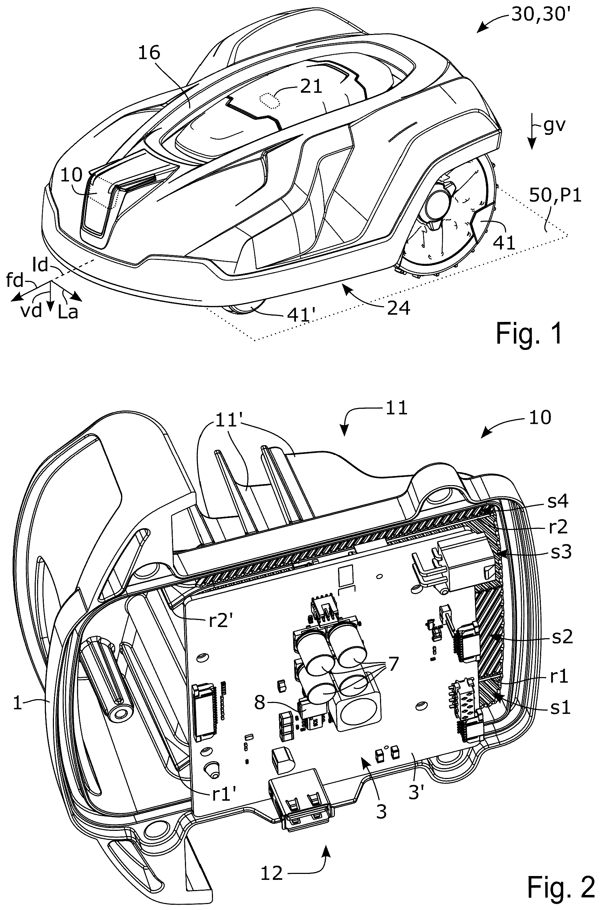

**Fig. 1** schematically illustrates a perspective view of a robotic lawnmower 30 according to some embodiments of the present disclosure. The robotic lawnmower 30 is a self-propelled autonomous robotic lawnmower 30 capable of navigating and operating an area in an autonomous manner in an area without the intervention or the direct control of a user. For reasons of brevity and clarity, the self-propelled autonomous robotic lawnmower 30 is in some places herein referred to as "the robotic lawnmower 30" or simply "the lawnmower 30". Since the robotic lawnmower 30 is a type of apparatus, the robotic lawnmower 30 has also been provided with the reference sign 30' in Fig. 1. According to the embodiments herein, the robotic lawnmower 30 is a small or mid-sized robotic lawnmower 30 configured to be used to cut grass in areas used for aesthetic and recreational purposes, such as gardens, parks, city parks, sports fields, lawns around houses, apartments, commercial buildings, offices, and the like.

The robotic lawnmower 30 comprises a lawnmower body 16 and a number of lawnmower support members 41, 41' each configured to abut against a ground surface 50 in a ground engaging plane P1 during operation of the robotic lawnmower 30 to support the lawnmower body 16. The lawnmower body 16, as referred to herein, may also be referred to as a lawnmower chassis. The ground engaging plane P1 extends through ground engaging portions of the lawnmower support members 41, 41' of the robotic lawnmower 30. Accordingly, the ground engaging plane P1 will extend along a ground surface 50 when the robotic lawnmower 30 is positioned on a flat ground surface 50.

According to the illustrated embodiments, the lawnmower support members 41, 41' is wheels 41, 41' of the robotic lawnmower 30. In more detail, according to the illustrated embodiments, the robotic lawnmower 30 comprises four wheels 41, 41', namely two drive wheels 41 and two support wheels 41'. The drive wheels 41 of the robotic lawnmower 30 may each be powered by an electrical motor of the robotic lawnmower 30 to provide motive power and/or steering of the robotic lawnmower 30. In Fig. 1, a longitudinal direction Id of the robotic lawnmower 30 is indicated. The longitudinal direction Id of the robotic lawnmower 30 extends in a lateral longitudinal plane of the robotic lawnmower 30. The lateral longitudinal plane is parallel to the ground engaging plane P1.

The longitudinal direction Id of the robotic lawnmower 30 is thus parallel to the ground engaging plane P1 and thus also to a ground surface 50 when the robotic lawnmower 30 is positioned in an upright use position on a flat ground surface 50. Moreover, the longitudinal direction Id of the robotic lawnmower 30 is parallel to a forward moving direction fd of the robotic lawnmower 30 as well as a reverse moving direction of the robotic lawnmower 30. The reverse moving direction is opposite to the forward moving direction fd.

A lateral direction La of the robotic lawnmower 30 is also indicated in Fig. 1. The lateral direction La is parallel to the lateral longitudinal plane or the robotic lawnmower 30, and is thus also parallel to the ground engaging plane P1. Moreover, the lateral direction La is perpendicular to the longitudinal direction Id of the robotic lawnmower 30.

Furthermore, in Fig. 1, a vertical direction vd of the robotic lawnmower 30 is indicated. The vertical direction vd of the robotic lawnmower 30 is perpendicular to the lateral longitudinal plane or the robotic lawnmower 30, and is thus also perpendicular to the ground engaging plane P1. As understood from the above, the vertical direction vd of the robotic lawnmower 30 is also perpendicular to the longitudinal direction Id of the robotic lawnmower 30 and the lateral direction La of the robotic lawnmower 30. A gravity vector gv is schematically indicated in Fig. 1. The vertical direction vd of the robotic lawnmower 30 coincides with the gravity vector gv when the robotic lawnmower 30 is positioned in an upright use position on a flat horizontal surface 50.

According to the illustrated embodiments, the drive wheels 41 of the robotic lawnmower 30 are non-steered wheels having a fix rolling direction in relation to the lawnmower body 16. The respective rolling direction of the drive wheels 41 of the robotic lawnmower 30 is substantially parallel to the longitudinal direction Id of the robotic lawnmower 30. According to the illustrated embodiments, the support wheels 41' are non-driven wheels. Moreover, according to the illustrated embodiments, the support wheels 41' can pivot around a respective pivot axis such that the rolling direction of the respective support wheel 41' can follow a travel direction of the robotic lawnmower 30.

As understood from the above, when the drive wheels 41, 41' of the robotic lawnmower 30 are rotated at the same rotational velocity in a forward rotational direction, and no wheel slip is occurring, the robotic lawnmower 30 will move in the forward moving direction fd indicated in Fig. 1. Likewise, when the drive wheels 41, 41' of the robotic lawnmower 30 are rotated at the same rotational velocity in a reverse rotational direction, and no wheel slip is occurring, the robotic lawnmower 30 will move in the reverse moving direction.

According to the illustrated embodiments, the robotic lawnmower 30 may be referred to as a four-wheeled rear wheel driven robotic lawnmower 30. According to further embodiments, the robotic lawnmower 30 may be provided with another number of wheels 41, 41', such as three wheels. Moreover, according to further embodiments, the robotic lawnmower 30 may be provided with another configuration of driven and non-driven wheels, such as a front wheel drive or an all-wheel drive.

According to the illustrated embodiments, the robotic lawnmower 30 comprises a control arrangement 21. The control arrangement 21 may be configured to control propulsion of the robotic lawnmower 30, and steer the robotic lawnmower 30, by controlling electrical motors of the robotic lawnmower 30 arranged to drive the drive wheels 41 of the robotic lawnmower 30. According to further embodiments, the control arrangement 21 may be configured to steer the robotic lawnmower 30 by controlling the angle of steered wheels of the robotic lawnmower 30. According to still further embodiments, the robotic lawnmower may be an articulated robotic lawnmower, wherein the control arrangement 21 may be configured to steer the robotic lawnmower by controlling the angle between frame portions of the articulated robotic lawnmower.

The control arrangement 21 may be configured to control propulsion of the robotic lawnmower 30, and may be configured to steer the robotic lawnmower 30 so as to navigate the robotic lawnmower 30 in an area to be operated. The robotic lawnmower 30 may further comprise one or more sensors arranged to sense a magnetic field of a wire, and/or one or more positioning units, and/or one or more sensors arranged to detect an impending or ongoing collision event with an object. In addition, the robotic lawnmower 30 may comprise a communication unit connected to the control arrangement 21. The communication unit may be configured to communicate with a remote communication unit to receive instructions therefrom and/or to send information thereto. The communication may be performed wirelessly over a wireless connection such as the internet, or a wireless local area network (WLAN), or a wireless connection for exchanging data over short distances using short-wavelength, i.e. ultra-high frequency (UHF) radio waves in the industrial, scientific, and medical (ISM) band from 2.4 to 2.486 GHz.

The control arrangement 21 may be configured to control propulsion of the robotic lawnmower 30, and steer the robotic lawnmower 30, so as to navigate the robotic lawnmower 30 in a systematic and/or random pattern to ensure that an area is completely covered, using input from one or more of the above described sensors and/or units.

Furthermore, the robotic lawnmower 30 may comprise one or more batteries arranged to supply electricity to components of the robotic lawnmower 30. As an example, the one or more batteries may be arranged to supply electricity to electrical motors of the robotic lawnmower 30 by an amount controlled by the control arrangement 21.

The robotic lawnmower 30 comprises a cutting arrangement 24 configured to cut vegetation, such as grass. The cutting arrangement 24 may comprise one or more cutting units, such as cutting discs or cutting arms. Moreover, as schematically depicted in Fig. 1, the robotic lawnmower 30 comprises an electronic arrangement 10. According to the embodiments illustrated in Fig. 1, the electronic arrangement 10 is arranged at a front portion of the robotic lawnmower 30 as seen relative to the forward moving direction fd of the robotic lawnmower 30. However, according to further embodiments, the electronic arrangement 10 may be arranged at another portion of the robotic lawnmower 30.

**Fig. 2** schematically illustrates a perspective view of the electronic arrangement 10 of the robotic lawnmower 30 illustrated in Fig. 1. The electronic arrangement 10 comprises an electronic assembly 3 and a heat sink unit 1. As is further explained herein, the electronic assembly 3 is attached to the heat sink unit 1 such that a portion of the electronic assembly 3 is in heat exchanging contact with a heat transferring section of the heat sink unit 1.

According to the illustrated embodiments, the electronic assembly 3 comprises a circuit board 3' and a number of electrical components 7, 8 arranged on the circuit board 3'. In the depicted embodiments, the circuit board 3' is a printed circuit board. Moreover, according to the illustrated embodiments, the electronic assembly 3 comprises an electronic control unit 8. According to the illustrated embodiments, the electronic assembly 3 is configured to control operation of a sensor assembly, in more detail, an imaging unit sensor assembly. However, according to further embodiments, the electronic assembly 3, as referred to herein, may be arranged for a different purpose, such as for controlling operation of other aspects of the robotic lawnmower 30, such as power management, motor control, navigation, positioning, or communication with external devices.

According to further embodiments, the electronic assembly 3 may comprise one or more other types of electrical components, such as for example power transistors, voltage regulators, communication modules, memory units, or navigation processors. Moreover, the electrical components of the electronic assembly 3 may be arranged in another manner than on a circuit board 3'.

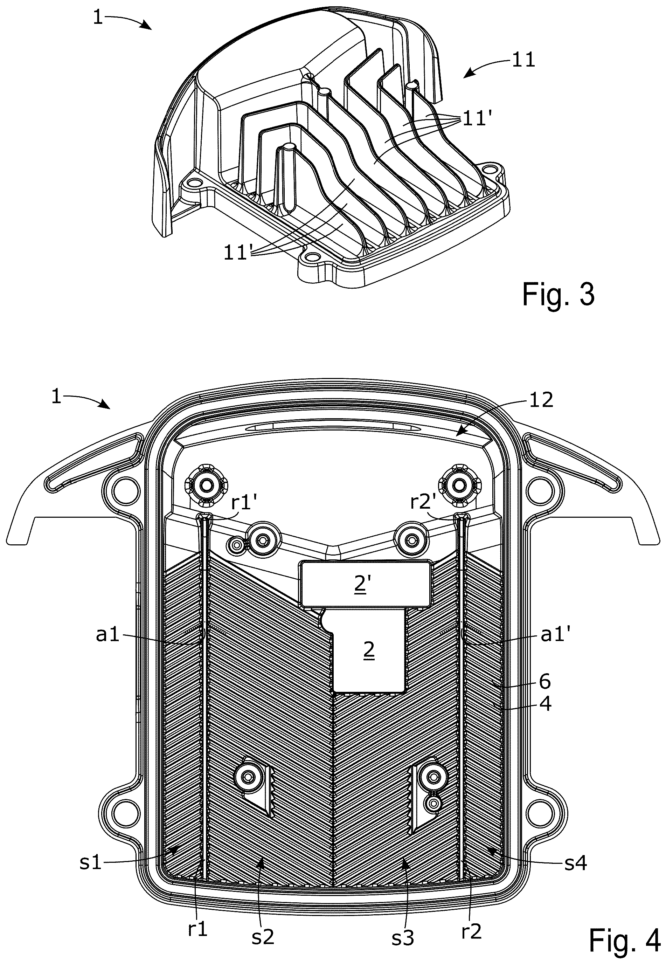

**Fig. 3** illustrates a perspective view of the heat sink unit 1 of the electronic arrangement 10 illustrated in Fig. 2. In Fig. 3, the heat sink unit 1 is illustrated as seen towards a top side 11 thereof. As can be seen in Fig. 3, the top side 11 comprises a plurality of heat sink members 11'. In more detail, according to the illustrated embodiments, each heat sink member 11' is formed as an elongated flange for providing an efficient transfer of heat from the heat sink unit 1 to surrounding air. According to the illustrated embodiments, the top side 11 comprises seven heat sink members 11', but may comprise another number of heat sink members 11', such as two or more heat sink members 11'. Moreover, the heat sink members 11' may be formed differently than as elongated flange members.

**Fig. 4** illustrates a bottom view of the heat sink unit 1 illustrated in Fig. 3. In Fig. 4, the heat sink unit 1 is illustrated as seen directly towards a bottom side 12 thereof. As can be seen in

Fig. 4, the heat sink unit 1 comprises two heat transferring sections 2, 2' on the bottom side 12 thereof. According to further embodiments, the heat sink unit 1 may comprise one heat transferring section, or more than two heat transferring sections 2, 2'.

Moreover, as seen in Fig. 4, as well as in Fig. 2, according to embodiments herein, the bottom side 12 of the heat sink unit 1 comprises a number of profiled surfaces s1, s2, s3, s4. Each of the number of profiled surfaces s1, s2, s3, s4 comprises a series of adjacent ridges 4 and grooves 6. According to the illustrated embodiments, the bottom side 12 of the heat sink unit 1 comprises four profiled surfaces s1, s2, s3, s4. However, according to further embodiments, the bottom side 12 of the heat sink unit 1 may comprise another number of profiled surfaces s1, s2, s3, s4, such as one or more profiled surfaces s1, s2, s3, s4. In some places herein the profiled surfaces s1, s2, s3, s4 of the bottom side 12 of the heat sink unit 1 are referred to as a first profiled surface s1, a second profiled surface s2, a third profiled surface s3, and a fourth profiled surface s4. The features, functions, and advantages of the profiled surfaces s1, s2, s3, s4 are further explained in detail below.

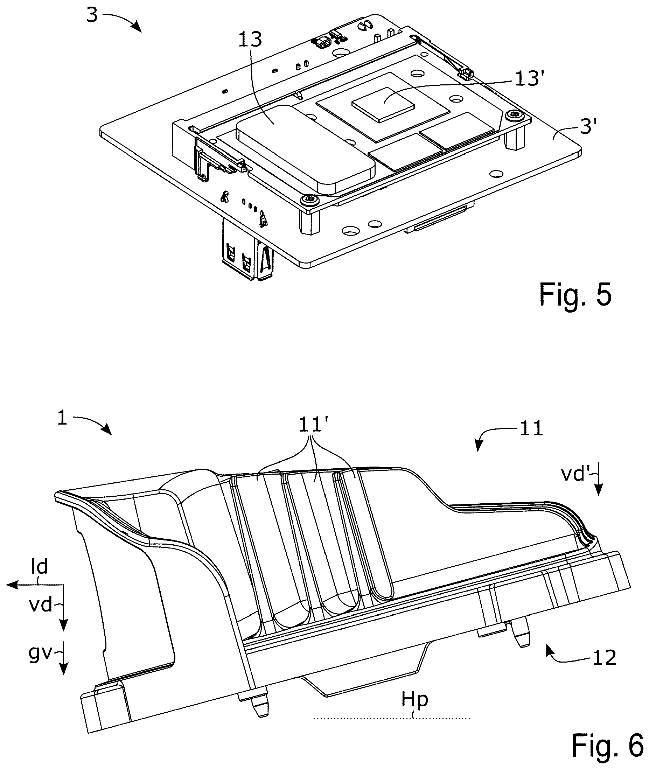

**Fig. 5** illustrates a perspective view of the electronic assembly 3 of the electronic arrangement 10 illustrated in Fig. 2. In Fig. 5, the electronic assembly 3 is illustrated as seen towards a bottom side thereof. The bottom side of the electronic assembly 3 abuts against the bottom side 12 of the heat sink unit 1 when the electronic arrangement 10 is in an assembled state, as depicted in Fig. 2.

In more detail, two portions 13, 13' of the electronic assembly 3 are indicated in Fig. 5. The two portions 13, 13' are arranged on the bottom side of the electronic assembly 3. When the electronic arrangement 10 is in the assembled state, as is depicted in Fig. 2, the portions 13, 13' of the electronic assembly 3 are in heat exchanging abutting contact with the heat transferring section 2, 2' of the heat sink unit 1. In this manner, the heat generated by the electrical components 7, 8 of the electronic assembly 3 can be efficiently transferred to surrounding air via the heat sink members 11' of the heat sink unit 1.

**Fig. 6** illustrates a side view of the heat sink unit 1 of the electronic arrangement 10 illustrated in Fig. 2. The following is explained with simultaneous reference to Fig. 1 - Fig. 6.

The heat sink unit 1 is configured to be mounted to an apparatus 30' such that, when the apparatus 30' is in an upright use position on a flat horizontal surface 50, a vertical direction vd' of the heat sink unit 1 coincides with the gravity vector gv. In Fig. 6, the gravity vector gv, the longitudinal direction Id, and the vertical direction vd of the robotic lawnmower 30 is indicated.

As understood from the above, the heat sink unit 1 is configured to be mounted to the robotic lawnmower 30, such that a vertical direction vd' of the heat sink unit 1 coincides with the vertical direction vd of the robotic lawnmower 30. Furthermore, in Fig. 6, a horizontal plane Hp of the heat sink unit 1 is indicated. The horizontal plane Hp of the heat sink unit 1 is perpendicular to the vertical direction vd' of the heat sink unit 1. In other words, the horizontal plane Hp of the heat sink unit 1 is parallel to the ground engaging plane P1, and thus also to a ground surface 50, when the heat sink unit 1 is mounted to the robotic lawnmower 30 and the robotic lawnmower 30 is positioned in an upright use position on a flat ground surface 50. Furthermore, as understood from the above, the horizontal plane Hp of the heat sink unit 1 is perpendicular to the gravity vector gv when the heat sink unit 1 is mounted to the robotic lawnmower 30 and the robotic lawnmower 30 is positioned in an upright use position on a flat ground surface 50.

As is further explained herein, each of the number of profiled surfaces s1, s2, s3, s4 is inclined relative to the horizontal plane Hp of the heat sink unit 1.

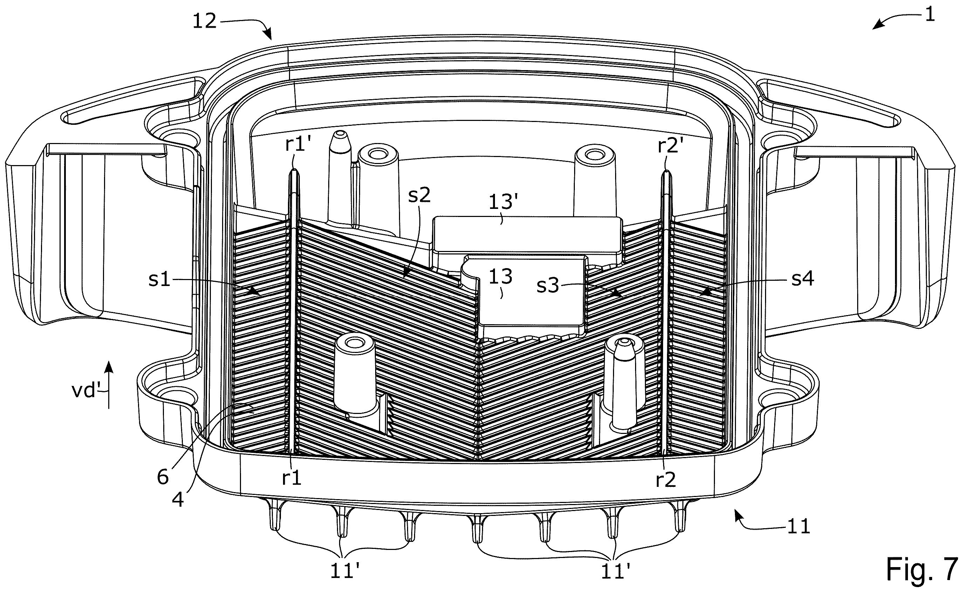

**Fig. 7** illustrates a perspective view of the heat sink unit 1 towards the bottom side 12 thereof. The vertical direction vd' of the heat sink unit 1 is also indicated in Fig. 7. Below, simultaneous reference is made to Fig. 1 - Fig. 7, if not indicated otherwise.

According to the illustrated embodiments, the heat sink unit 1 comprises four profiled surfaces s1, s2, s3, s4 and two moisture collecting ridges r1, r2. However, according to further embodiments, the heat sink unit 1 may comprise another number of profiled surfaces s1, s2, s3, s4 and moisture collecting ridges r1, r2.

In more detail, according to the illustrated embodiments, the number of profiled surfaces s1, s2, s3, s4 comprises a first profiled surface s1 and a first moisture collecting ridge r1, wherein the first moisture collecting ridge r1 is arranged adjacent to the first profiled surface s1. The first profiled surface s1 is inclined towards the first moisture collecting ridge r1. The feature that the first profiled surface s1 is inclined towards the first moisture collecting ridge r1 means that the first profiled surface s1 is angled relative to the horizontal plane Hp of the heat sink unit 1 and that the first moisture collecting ridge r1 is arranged at a lower part of the first profiled surface s1 as seen relative to the vertical direction vd' of the heat sink unit 1.

According to the illustrated embodiments, the angle between the first profiled surface s1 and the horizontal plane Hp is approximately 15 degrees. However, according to further embodiments, the angle between the first profiled surface s1 and the horizontal plane Hp may be within the range 7 - 45 degrees, or may be within the range of 10 - 20 degrees.

Moreover, as can be seen in Fig. 7, as well as in Fig. 4, the series of ridges 4 and grooves 6 of the first profiled surface s1 extends in directions towards the first moisture collecting ridge r1. In this manner, any moisture collected on the first profiled surface s1 can be efficiently transferred along the extension directions of the series of ridges 4 and grooves 6 to the first moisture collecting ridge r1 due to gravity in a controlled manner.

Furthermore, according to the illustrated embodiments, the number of profiled surfaces s1, s2, s3, s4 comprises a second profiled surface s2. As can be seen in Fig. 7, as well as in Fig. 4, the first moisture collecting ridge r1 is arranged between the first and second profiled surfaces s1, s2. In other words, the second profiled surface s2 is arranged adjacent to the first moisture collecting ridge r1 but on the opposite side of the first moisture collecting ridge r1 as compared to the first profiled surface s1.

The second profiled surface s2 is also inclined towards the first moisture collecting ridge r1 which means that the second profiled surface s2 is angled relative to the horizontal plane Hp of the heat sink unit 1 and that the first moisture collecting ridge r1 is arranged at a lower part of the second profiled surface s2 as seen relative to the vertical direction vd' of the heat sink unit 1.

According to the illustrated embodiments, the angle between the second profiled surface s2 and the horizontal plane Hp is approximately 15 degrees. However, according to further embodiments, the angle between the second profiled surface s2 and the horizontal plane Hp may be within the range 7 - 45 degrees, or may be within the range of 10 - 20 degrees.

In Fig. 7, only the series of ridges 4 and grooves 6 of the first profiled surface s1 have been indicated for reasons of brevity and clarity. Likewise, in Fig. 4, only the series of ridges 4 and grooves 6 of the fourth profiled surface s4 have been indicated for reasons of brevity and clarity.

However, as seen in Fig. 4 and Fig. 7, the series of ridges 4 and grooves 6 of the second profiled surface s2 extends in directions towards the first moisture collecting ridge r1. In this manner, any moisture collected on the second profiled surface s2 can be efficiently transferred along the extension directions of the series of ridges 4 and grooves 6 to the first moisture collecting ridge r1 due to gravity in a controlled manner.

As is indicated in Fig. 4, according to the illustrated embodiments, the series of ridges 4 and grooves 6 of the first and second profiled surfaces s1, s2 meet at an obtuse angle a1. More specifically, in the illustrated embodiments, the obtuse angle a1 is approximately 122 degrees. However, according to further embodiments, the series of ridges 4 and grooves 6 of the first and second profiled surfaces s1, s2 may meet at a different angle, including acute angles, for example, an angle within the range of 20 - 160 degrees.

According to the illustrated embodiments, the number of profiled surfaces s1, s2, s3, s4 comprises a third profiled surface s3 and a second moisture collecting ridge r2 arranged adjacent to the third profiled surface s3. The third profiled surface s3 is inclined towards the second moisture collecting ridge r2. Like above, the feature that the third profiled surface s3 is inclined towards the second moisture collecting ridge r2 means that the third profiled surface s3 is angled relative to the horizontal plane Hp of the heat sink unit 1 and that the second moisture collecting ridge r2 is arranged at a lower part of the third profiled surface s3 as seen relative to the vertical direction vd' of the heat sink unit 1.

According to the illustrated embodiments, the angle between the third profiled surface s3 and the horizontal plane Hp is approximately 15 degrees. However, according to further embodiments, the angle between the third profiled surface s3 and the horizontal plane Hp may be within the range 7 - 45 degrees, or may be within the range of 10 - 20 degrees.

Moreover, as can be seen in Fig. 7, as well as in Fig. 4, the series of ridges 4 and grooves 6 of the third profiled surface s3 extends in directions towards the second moisture collecting ridge r2. In this manner, any moisture collected on the third profiled surface s3 can be efficiently transferred along the extension directions of the series of ridges 4 and grooves 6 to the second moisture collecting ridge r2 due to gravity in a controlled manner.

Furthermore, according to the illustrated embodiments, the number of profiled surfaces s1, s2, s3, s4 comprises a fourth profiled surface s4. As can be seen in Fig. 7, as well as in Fig. 4, the second moisture collecting ridge r2 is arranged between the first and second profiled surfaces s1, s2. In other words, the fourth profiled surface s4 is arranged adjacent to the second moisture collecting ridge r2 but on the opposite side of the second moisture collecting ridge r2 as compared to the third profiled surface s3.

The fourth profiled surface s4 is also inclined towards the second moisture collecting ridge r2 which means that the fourth profiled surface s4 is angled relative to the horizontal plane Hp of the heat sink unit 1 and that the second moisture collecting ridge r2 is arranged at a lower part of the fourth profiled surface s4 as seen relative to the vertical direction vd' of the heat sink unit 1.

According to the illustrated embodiments, the angle between the fourth profiled surface s4 and the horizontal plane Hp is approximately 15 degrees. However, according to further embodiments, the angle between the fourth profiled surface s4 and the horizontal plane Hp may be within the range 7 - 45 degrees, or may be within the range of 10 - 20 degrees.

As seen in Fig. 4 and Fig. 7, the series of ridges 4 and grooves 6 of the fourth profiled surface s4 extends in directions towards the second moisture collecting ridge r2. In this manner, any moisture collected on the fourth profiled surface s4 can be efficiently transferred along the extension directions of the series of ridges 4 and grooves 6 to the second moisture collecting ridge r2 due to gravity in a controlled manner.

As is indicated in Fig. 4, according to the illustrated embodiments, the series of ridges 4 and grooves 6 of the first and second profiled surfaces s1, s2 meet at an obtuse angle a1'. More specifically, in the illustrated embodiments, the obtuse angle a1' is approximately 122 degrees. However, according to further embodiments, the series of ridges 4 and grooves 6 of the first and second profiled surfaces s1, s2 may meet at a different angle, including acute angles, for example, an angle within the range of 20 - 160 degrees.

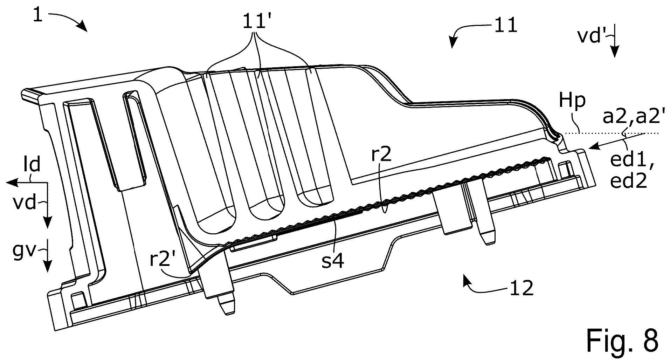

**Fig. 8** illustrates a cross section of the heat sink unit 1 illustrated in Fig. 6. In Fig. 8, the cross section is made in a plane perpendicular to the horizontal plane Hp of the heat sink unit 1. Moreover, in Fig. 8, the cross-section plane is made at a location adjacent to the second moisture collecting ridge r2. Also in Fig. 8, the vertical direction vd' of the heat sink unit 1 is indicated.

In Fig. 8, portions of the fourth profiled surface s4 and the second moisture collecting ridge r2 are seen. Below, simultaneous reference is made to Fig. 1 - Fig. 8, if not indicated otherwise. The extension directions ed1, ed2 of the first and second moisture collecting ridges r1, r2 have been indicated in Fig. 8. According to the illustrated embodiments, the first moisture collecting ridge r1 has identical design as the second moisture collecting ridge r2. In other words, the extension direction ed1 of the first moisture collecting ridge r1 is parallel to the extension direction ed2 of the second moisture collecting ridge r2. However, according to further embodiments, the extension direction ed1 of the first moisture collecting ridge r1 may not be parallel to the extension direction ed2 of the second moisture collecting ridge r2.

According to the illustrated embodiments, the angles a2, a2' between the extension directions ed1, ed2 of the first and second moisture collecting ridges r1, r2 and the horizontal plane Hp of the heat sink unit 1 is approximately 15 degrees. However, according to further embodiments, the angles a2, a2' between the extension directions ed1, ed2 of the first and second moisture collecting ridges r1, r2 and the horizontal plane Hp may be within the range of 7 - 45 degrees, or may be within the range of 10 - 20 degrees. In this manner, it can be ensured that moisture collected from the profiled surfaces s1, s2, s3, s4 can be transferred along the first and second moisture collecting ridges r1, r2 due to gravity.

An end portion r2' of the second moisture collecting ridge r2 is indicated in Fig. 8. The end portion r2' of the second moisture collecting ridge r2, as well as an end portion r1' of the first moisture collecting ridge r1, are also seen in Fig. 2, Fig. 4, and Fig. 7. As seen in these figures, according to the illustrated embodiments, the end portions r1', r2' of the first and second moisture collecting ridges r1, r2 are formed as a stalactite-like portion designed to facilitate the dripping of liquid from the moisture collecting ridge r1, r2. As is best seen in Fig. 2, the end portions r1', r2' of the first and second moisture collecting ridges r1, r2 are located further out from the electronic assembly 3, ensuring that drops leaving the respective end portion r1', r2' do not hit the electronic assembly 3 when the heat sink unit 1 is held in its intended mounting orientation relative to a gravity vector gv, as is illustrated in Fig. 6 and Fig. 8.

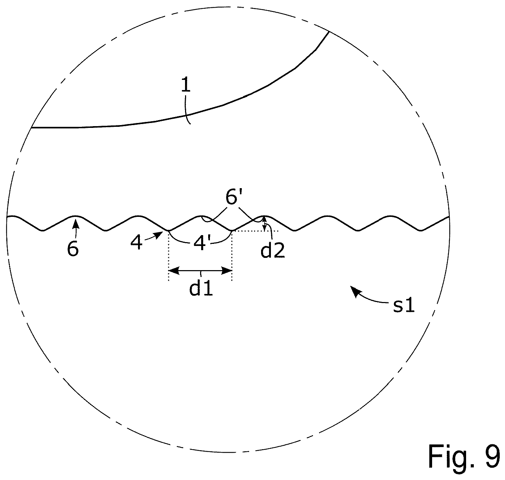

**Fig. 9** illustrates a cross-section of a portion of the heat sink unit 1, comprising the first profiled surface s1. In Fig. 9, the cross-section is made in a plane perpendicular to the extension directions of the series of ridges 4 and grooves 6 of the first profiled surface s1. Below, simultaneous reference is made to Fig. 1 - Fig. 9, if not indicated otherwise.

According to the illustrated embodiments, the series of ridges 4 and grooves 6 have an identical design across the number of profiled surfaces s1, s2, s3, s4. Therefore, the series of ridges 4 and grooves 6 of the first profiled surface s1, as seen in Fig. 9, are also representative of the series of ridges 4 and grooves 6 of the second, third, and fourth profiled surfaces s2, s3, s4.

According to the illustrated embodiments, the distance d1 between two adjacent ridges 4 of the number of profiled surfaces s1, s2, s3, s4 is 1.91 millimetres. However, according to further embodiments, the distance d1 between two adjacent ridges 4 of the number of profiled surfaces s1, s2, s3, s4 may be within the range of 0.5 - 5.5 millimetres, or may be within the range of 1.5 - 2.3 millimetres.

Moreover, according to the illustrated embodiments, the distance d2 between a peak 4' of the ridges 4 and a valley 6' of the grooves 6 is 0.44 millimetres. However, according to further embodiments, the distance d2 between a peak 4' of the ridges 4 and a valley 6' of the grooves 6 may be within the range of 0.15 - 1.5 millimetres, or may be within the range of 0.34 - 0.54 millimetres.

Studies have shown that measurements within these ranges can improve the moisture collecting properties of the profiled surfaces s1, s2, s3, s4, as well as enhance the ability to direct moisture along the extension directions of the series of ridges 4 and grooves 6 towards a moisture collecting ridge r1, r2.

It is to be understood that the foregoing is illustrative of various example embodiments and that the invention is defined only by the appended independent claims. A person skilled in the art will realize that the example embodiments may be modified, and that different features of the example embodiments may be combined to create embodiments other than those described herein, without departing from the scope of the present invention, as defined by the appended independent claims.

As used herein, the term "comprising" or "comprises" is open-ended, and includes one or more stated features, elements, steps, components, or functions but does not preclude the presence or addition of one or more other features, elements, steps, components, functions, or groups thereof.

## Claims

1. A heat sink unit (1) configured to conduct heat away from an electronic assembly (3), the heat sink unit (1) comprising:
- a top side (11) comprising a plurality of heat sink members (11'), and
- a bottom side (12) comprising a heat transferring section (2, 2') configured to be in heat exchanging contact with a portion (13, 13') of the electronic assembly (3),
wherein the bottom side (12) comprises a number of profiled surfaces (s1, s2, s3, s4) each comprising a series of adjacent ridges (4) and grooves (6),
**characterized in that** the heat sink unit (1) is configured to be mounted to an apparatus (30') such that, when the apparatus (30') is in an upright use position on a flat horizontal surface (50), a vertical direction (vd') of the heat sink unit (1) coincides with the gravity vector (gv), and wherein each of the number of profiled surfaces (s1, s2, s3, s4) is inclined relative to a horizontal plane (Hp) of the heat sink unit (1), the horizontal plane (Hp) being perpendicular to the vertical direction (vd') of the heat sink unit (1), and wherein the number of profiled surfaces (s1, s2, s3, s4) comprises a first profiled surface (s1) and a first moisture collecting ridge (r1) arranged adjacent to the first profiled surface (s1).

2. The heat sink unit (1) according to claim 1, wherein the distance (d1) between two adjacent ridges (4) of the number of profiled surfaces (s1, s2, s3, s4) is within the range of 0.5 - 5.5 millimetres, or is within the range of 1.5 - 2.3 millimetres.

3. The heat sink unit (1) according to claim 1 or 2, wherein the distance (d2) between a peak (4') of the ridges (4) and a valley (6') of the grooves (6) is within the range of 0.15 - 1.5 millimetres, or is within the range of 0.34 - 0.54 millimetres.

4. The heat sink unit (1) according to any one of the preceding claims, wherein the first profiled surface (s1) is inclined towards the first moisture collecting ridge (r1).

5. The heat sink unit (1) according to any one of the preceding claims, wherein the angle between the first profiled surface (s1) and the horizontal plane (Hp) is within the range 7 - 45 degrees, or is within the range of 10 - 20 degrees.

6. The heat sink unit (1) according to any one of the preceding claims, wherein the angle (a2) between the extension direction (ed1) of the first moisture collecting ridge (r1) and the horizontal plane (Hp) is within the range of 7 - 45 degrees, or is within the range of 10 - 20 degrees.

7. The heat sink unit (1) according to any one of the preceding claims, wherein the number of profiled surfaces (s1, s2, s3, s4) comprises a second profiled surface (s2), and wherein the first moisture collecting ridge (r1) is arranged between the first and second profiled surfaces (s1, s2).

8. The heat sink unit (1) according to claim 7, wherein the second profiled surface (s2) is inclined towards the first moisture collecting ridge (r1).

9. The heat sink unit (1) according to claim 7 or 8, wherein the angle between the second profiled surface (s2) and the horizontal plane (Hp) is within the range 7 - 45 degrees, or is within the range of 10 - 20 degrees.

10. The heat sink unit (1) according to any one of the claims 7 - 9, wherein the series of ridges (4) and grooves (6) of the first and second profiled surfaces (s1, s2) meet at an obtuse angle (a1).

11. The heat sink unit (1) according to any one of the claims 7 - 10, wherein the number of profiled surfaces (s1, s2, s3, s4) comprises a third profiled surface (s3) and a second moisture collecting ridge (r2) arranged adjacent to the third profiled surface (s3).

12. An electronic arrangement (10) comprising an electronic assembly (3) and a heat sink unit (1) according to any one of the preceding claims, wherein the electronic assembly (3) is attached to the heat sink unit (1) such that a portion (13, 13') of the electronic assembly (3) is in heat exchanging contact with the heat transferring section (2, 2') of the heat sink unit (1).

13. The electronic arrangement (10) according to claim 12, wherein the electronic assembly (3) comprises a circuit board (3') and a number of electrical components (7, 8) arranged on the circuit board (3').

14. The electronic arrangement (10) according to claim 12 or 13, wherein the electronic assembly (3) comprises at least one electronic control unit (8).

15. A robotic lawnmower (30) comprising a heat sink unit (1) according to any one of the claims 1 - 11 or an electronic arrangement (10) according to any one of the claims 12 - 14.
